# EUROPÄISCHE PATENTSCHRIFT

(11) **EP 0 585 256 B1**
(45) Veröffentlichungstag und Bekanntmachung des Hinweises auf die Patenterteilung: **11.09.1996**
(21) Anmeldenummer: 92909291.4
(22) Anmeldetag: 08.05.1992
(51) Int. Cl.: H01L 21/18, H01L 21/20

(54) **DIREKTES SUBSTRATBONDEN**
DIRECT SUBSTRATE BONDING
LIAISON DIRECTE SUR UN SUBSTRAT

(30) Priorität: 08.05.1991 DE 4115046
(43) Veröffentlichungstag der Anmeldung: 09.03.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: QUENZER, Hans, Joachim, D-1000 Berlin 45 (DE); BENECKE, Wolfgang, D-27412 Vorwerk-Buchholz (DE)
(74) Vertreter: Münich, Wilhelm, Dr.
(86) Internationale Anmeldenummer: DE9200365
(87) Internationale Veröffentlichungsnummer: WO9220094

(56) Entgegenhaltungen:
- ELECTRONICS LETTERS. Bd. 23, Nr. 1, 2. Januar 1987, STEVENAGE GB Seiten 39 - 40; A.YAMADA ET AL.: 'SOI BY WAFER BONDING WITH SPIN-ON GLASS AS ADHESIVE.'
- EXTENDED ABSTRACTS OF THE 20TH (1988 INTERNATIONAL) CONFERENCE ON SOLID STATE DEVICES AND MATERIALS. 24-26/08/1988 TOKYO 1988 TOKYO Seiten 197 - 200; X. X. LI ET AL.: 'SI ON SIO2 BY SOLID STATE DIFFUSION BONDING (SSDB) TECHNOLOGY'
- JOURNAL OF APPLIED PHYSICS. Bd. 64, Nr. 10, 15. November 1988, NEW-YORK US Seiten 4943 - 4950; W.P. MASZARA ET AL.: 'BONDING OF SILICON WAFERS FOR SILICON-ON-INSULATOR'
- JAPANESE JOURNAL OF APPLIED PHYSICS. Bd. 28, Nr. 8, August 1989, TOKYO JP Seiten 1426 - 1443; J. H. HAISMA ET AL.: 'SILICON-ON-INSULATOR WAFER BONDING- WAFER THINNING TECHNOLOGICAL EVALUATIONS'
- APPLIED PHYSICS LETTERS. Bd. 56, Nr. 24, 11. Juni 1990, NEW YORK US Seiten 2419 - 2421; E. YABLONOVITCH ET AL.: 'VAN DER WAALS BONDING OF GAAS EPITAXIAL LIFTOFF FILMS ONTO ARBITRARY SUBSTRATES'
- PATENT ABSTRACTS OF JAPAN vol. 008, no. 226 (E-272)17. Oktober 1984 & JP-A-59 106 121
- PATENT ABSTRACTS OF JAPAN vol. 012, no. 127 (E-602)20. April 1988 & JP-A-62 252 141

## Beschreibung

### Technisches Gebiet

Die Erfindung bezieht sich auf ein Verfahren zur Herstellung einer festen, flächenhaften Verbindung zwischen zwei Wafer-Platten, von denen mindestens eine aus einem halbleitenden Material, z.B. Silizium, besteht.

### Stand der Technik

In der Mikrostrukturtechnik ist es bei der Herstellung komplexer Mikrosysteme, die beispielsweise Sensoren, Aktoren sowie mikroelektronischen Schaltungen aufweisen können, aus Herstellgründen von Vorteil, wenn - getrennt hergestellte und bearbeitete - Wafer-Platten aus gleichem oder unterschiedlichem Material flächig und dauerhaft zu einem komplexen Mikrosystem verbunden werden.

Die Herstellung einer Schichtenfolge beispielsweise mit einem epitaktischen Verfahren hat nämlich den Nachteil, daß die zum Teil sehr komplexen und kostspieligen Epitaxieanlagen einen hohen Investitionsaufwand erfordern. Demgegenüber gilt die Herstellung von Halbleiterschichtenfolgen durch Verbindungstechniken als eine kostengünstige Alternative.

Die bekannten Verbindungstechniken für Wafer-Platten haben jedoch eine Reihe von z.T. unterschiedlichen Nachteilen:

Bei den bekannten Direkt-Substrat-Bond-Verfahren sind für den Tempervorgang Temperaturen im Bereich zwischen 700°C und 1100°C erforderlich. Erst diese hohen Temperaturen ergeben nämlich fest zusammenhaftende Wafer-Platten, die für die weiterverarbeitenden Arbeitsschritte eine ausreichende Haftkraft besitzen.

Hierzu wird beispielsweise auf die EP-A-0 136 050 verwiesen, in der ausdrücklich ausgeführt wird, daß die "zusammenhaftenden" Silizium-Wafer erst bei Temperaturen von mehr als 600°C die notwendige Haftkraft erreichen.

Ferner ist aus der US-PS 4 883 215 eine Verbindungstechnik bekannt, die ähnlich dem sog. "Aufsprengen" von Glaselementen funktioniert. Mit dieser Verbindungstechnik ist es möglich, nicht nur Silizium-Wafer-Platten, sondern auch Wafer-Platten aus Silizium und aus Isolatormaterialen, wie z.B. Glas oder Halbleiteroxide zu verbinden.

Bei dieser Verbindungstechnik sind zwar keine Tempervorgänge bei hohen Temperaturen erforderlich, die Adhäsionskraft zwischen den Platten ist jedoch für eine Reihe von Einsatzfällen nicht ausreichend.

Weiterhin ist aus der US-PS 4 962 062 ein Verfahren zur Verbindung zweier Halbleiter-Wafer-Platten mittels einer Zwischenschicht bekannt. Bei diesem bekannten Verfahren ist es jedoch erforderlich, in wenigstens eine Oberfläche eine spezielle Ausnehmung einzubringen, durch die die Haftung erst vermittelt wird. Darüberhinaus sind auch bei diesem Verfahren Tempervorgänge bei Temperaturen zwischen ca 500°C und 1200°C erforderlich.

Damit ist es auch bei diesem bekannten Verfahren aufgrund hoher der hohen Prozeßtemperaturen und der speziellen Vorbereitung der Waferoberflächen nur mit Schwierigkeiten möglich, Wafer-Platten, die bereits über mikroelektronische Oberflächenstrukturen verfügen, - sogenannte prozessierte Wafer-Platten - zu verbinden, da in der Regel die maximale Temperatur, mit der prozessierte Standard-Silizium-Substrate noch verarbeitet werden können, bei 420°C liegt.

Diese niedrigen Temperaturen als Tempertemperaturen sind nach dem Stand der Technik nur dann ausreichend, wenn Bonding-Verfahren angewendet werden, die Glas entweder als Substratmaterial oder aber als Zwischenschicht verwenden:

Bei dem sogenannten Anodic-Bonding-Verfahren, wird Pyrexglas als Substratmaterial bei etwa 300°C mit einem Silizium-Wafer durch Anlegen eines starken elektrischen Feldes verbunden. Nachteilig hierbei ist die notwendige Beschränkung auf das Substratmaterial Pyrexglas, wodurch sich gegenüber der Verwendung von Silizium eine Vielzahl von Prozessen von selbst verbieten (z.B. anisotropes Ätzen, elektrochemischer Ätzscop).

Weiterhin ist es bekannt daß zum Verbinden zweier Silizium-Substrate eine Glasschicht als Zwischenschicht verwendet werden kann, die beispielsweise aus Pyrex- oder Bleiglasschichten (Dicke ca. 0,5 bis 5 µm) besteht, die durch Sputtern auf einen der beiden Wafer aufgebracht werden.

Andererseits finden auch Borsilikatgläser, die entweder über CVD-Prozesse oder durch Dotierung hergestellt werden, in der Bonding-Technik Anwendung, indem sie auf den unbeschichteten Wafer bei etwa 460°C gepreßt werden.

Als problematisch sind hierbei die zu hohe Verarbeitungstemperatur sowie die ausgeprägte Tendenz zu nennen, auf der Borsilikatglasoberfläche Borsäure auszuscheiden, wodurch die Wafer-Plattenverbindung häufig unmöglich gemacht wird.

Alle bekannten auf Bonding-Verfahren beruhenden Verbindungstechniken weisen damit die Nachteile auf, daß jeweils nur spezielle Wafer-Materialkombinationen bei den einzelnen Verfahren verwendbar sind, daß die Haftkraft zwischen den Wafer-Platten nur begrenzt den Anforderungen nachgeschalteter Arbeitsprozesse genügt, und daß die zum Teil hohen Temperaturen bei den Tempervorgängen von mehr als 420°C die Verbindung "vor-prozessierter" Wafer-Platten unmöglich macht.

Andererseits sind die bekannten "Niedrigtemperatur-Verfahren" in der Regel auf ein spezielles Substratmaterial beschränkt und darüberhinaus aufwendig und damit kostspielig durchzuführen.

### Beschreibung der Erfindung

Der Erfindung liegt die Aufgabe zugrunde, ein Verfahren zur Herstellung einer festen, flächenhaften Verbindung zwischen zwei insbesondere hochpolierten Wafer-Platten, von denen mindestens eine aus einem halbleitenden Material, wie z.B. Silizium, besteht, anzugeben, das eine möglichst große Haftkraft zwischen den Wafer-Platten gewährleistet und das verschiedene Wafer-Platten-Materialkombinationen zuläßt.

Darüberhinaus sollen die einzelnen Verfahrensschritte einfach und mit den Mitteln bekannter Arbeitsprinzipien anwendbar sein, so daß das erfindungsgemäße Verfahren kostenünstig ausführbar ist.

Eine erfindungsgemäße Lösung dieser Aufgabe ist im Anspruch 1 angegeben. Weiterbildungen der Erfindung sind Gegenstand der Unteransprüche.

Erfindungsgemäß wird ein Verfahren zur Herstellung einer festen, flächenhaften Verbindung zwischen zwei insbesondere hochpolierten (Anspruch 2) Wafer-Platten angegeben, von denen mindestens eine aus einem halbleitenden Material, wie z.B. Silizium, besteht, das folgende Verfahrensschritte aufweist:
- auf die gereinigte Oberfläche wenigstens einer Wafer platte wird ein Film mit einer Restfeuchte an Lösungsmitteln aufgebracht, der Silikate oder Phosphate enthält,
- die beiden Waferoberflächen, von denen auf wenigstens eine ein Film aufgebracht ist, werden zusammengefügt,
- die beiden Wafer werden im zusammengefügten Zustand bei Temperaturen kleiner als ca 420°C getempert.

Die so entstandene Verbindung zeichnet sich sowohl durch eine hohe mechanische Festigkeit als auch durch eine große mechanische und chemische Beständigkeit aus. Messungen haben ergeben, daß die mechanische Haftkraft im Bereich zwischen 250 und 300 kg/cm² liegt. Diese hohen Haftkräfte ermöglichen somit eine problemlose Weiterbearbeitung der Wafer-Platten für die Herstellung von z.B. hochkomplexen Mikrostrukturen oder Sensoren oder dgl. mehr.

Bei der Verwendung von Silikaten kann die Temperung sogar bei Temperaturen zwischen 150°C und 300°C erfolgen, während bei der Verwendung von Phosphaten der Tempervorgang bei Temperaturen zwischen 300°C und 420°C beispielsweise in einem Ofen erfolgt (Anspruch 5).

Der Tempervorgang sorgt für ein Abbinden der Zwischenschichten. Das dabei freiwerdende Wasser kann z.B. von der Silizium- oder Siliziumoxid-Oberfläche des Silizium-Wafers aufgenommen und chemisch gebunden werden. Dieser Vorgang funktioniert allerdings nur an dünnen Schichten (≤ 100 nm - s. Anspruch 4) zuverlässig, da andernfalls ein zu großes Wasserangebot bzw. Lösungsmittelangebot zu einer Blasenbildung führen würde.

Als besonders zweckmäßig hat sich erwiesen, die Wafer zunächst nach ihrer Fixierung bei Raumtemperatur - insbesondere für ca. 24 Stunden - zu lagern und dann erst zu tempern (Anspruch 7).

Durch die Ausbildung einer sehr dünnen Zwischenschicht werden zudem keine nennenswerte mechanische Spannungen hervorgerufen (Anspruch 17). Dabei ist von besonderem Vorteil, daß die unmittelbar nach dem Zusammenfügen der Waferplatten durch den Film verursachten Haftkräfte jegliche Waferverzüge ausgleichen.

Das Lösungsmittel, von dem der Film zumindest eine gewisse Restfeuchte aufweist, kann im Prinzip jedes beliebige Lösungsmittel für die aufzubringenden Stoffe sein; besonders bevorzugt ist jedoch gerade unter Umweltgesichtspunkten, aber auch unter Verfahrensgesichtspunkten die im Anspruch 3 gekennzeichnete Verwendung von Wasser.

In jedem Falle ist es für die Haftkraft von Vorteil, wenn die zusammenzufügenden Waferoberflächen nach Anspruch 6 vor dem Aufbringen des Films gereinigt und getrocknet werden.

Das erfindungsgemäße Verfahren ist weitgehend unabhängig von dem Material der Wafer-Platten:

Beispielsweise können nach Anspruch 8 die Wafer-Platten metallisierte Bereiche aufweisen.

Weiterhin kann ein Wafer ein Siliziumwafer und das andere Wafer ein Quarzglaswafer (Anspruch 9), ein GaAs-Wafer (Anspruch 10) oder ein InP-Wafer (Anspruch 11) sein, wobei diese in den Ansprüchen gegebene Aufzählung für Wafer-Materialien nicht vollständig ist.

Die Anwendbarkeit des erfindungsgemäßen Verfahrens für die unterschiedlichsten Materialien ist insbesondere eine Folge der Tatsache, daß bereits bei Temperaturen von ca. 200°C bis 300°C die erreichten Verbindungen außerordentlich fest sind. Damit wird die Möglichkeit eröffnet, Substrate unterschiedlichster Art zu verbinden, insbesondere solche, die ein unterschiedliches Temperaturverhalten zeigen.

Deshalb können mit dem erfindungsgemäßen Verfahren Verbindungen zwischen Wafern aus Silizium und Quarzglas hergestellt werden. Ebenso sind Verbindungen mit anderen halbleitenden Materialien oder optisch aktiven Materialien wie z.B. Lithiumniobat möglich (Anspruch 12).

Im letzteren Fall ist es jedoch vorteilhaft, wenn eine Oxid-Zwischenschicht bzw. Waferschicht vorgesehen wird, die z.B. aus einem Spin-on-Glas bestehen kann (Ansprüche 13 bzw. 14).

In den Ansprüchen 15 und 16 sind ohne Beschränkung der allgemeinen Anwendbarkeit Beispiele für das Filmmaterial, nämlich Natriumsilikat und Aluminiumphosphat angegeben.

Der erfindungsgemäß vorgesehene Film kann als Flüssigkeitsfilm aufgebracht werden (Anspruch 18). Besonders vorteilhaft ist es jedoch, wenn das mit einer Restfeuchte behaftete Filmmaterial mit einem Trockenschleuderverfahren aufgebracht wird (Anspruch 19).

### Kurze Beschreibung der Zeichnung

Die Erfindung wird nachstehend anhand eines Ausführungsbeispiels anhand der Zeichnung exemplarisch beschrieben, in der zeigen:
Fig. 1 die Waferkonditionierung,
Fig. 2 das Aufbringen eines Films, und
Fig. 3 die Wafer-Platten im zusammengefügten Zustand.

### Beschreibung eines Ausführungsbeispiels

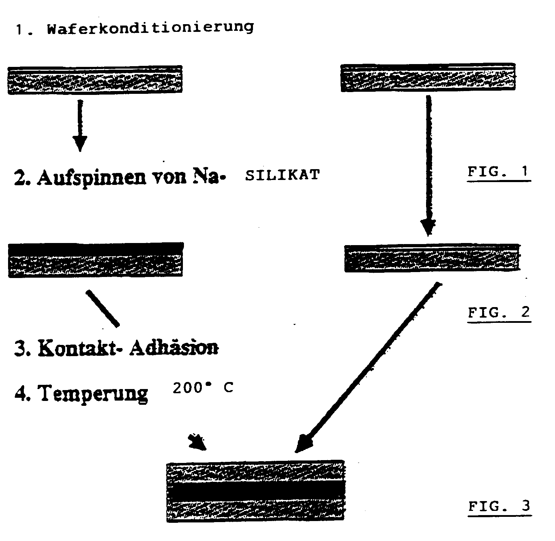

Fig. 1 zeigt die Konditionierung der beiden zusammenzufügenden Wafer. Die Wafer werden zunächst hochpoliert, so daß die Oberflächen, mit denen sie zusammengefügt werden sollen, "Spiegeloberflächen" mit sehr geringer Partikeldichte sind. Für eine dauerhafte und feste Verbindung zwischen den Wafer-Platten ist nämlich eine hochpolierte Oberfläche der sich gegenüberliegenden Wafer-Platten von besonderem Vorteil.

In einem anschließenden Reinigungsschritt werden die Oberflächen mittels einer Reinigungslösung, wie z.B. Salpetersäure, Pirania-Ätze, Ammoniak-Wasserstoffperoxid, RCA-Reinigung, von oberflächigen Schmutzpartikeln befreit.

Die Wafer werden sodann gespült und getrocknet. Hierbei wird im wesentlichen auf bekannte Schleudertechniken zurückgegriffen.

Fig. 2 zeigt, daß in einem weiteren Schritt auf eines der beiden Wafer, nämlich auf die Oberfläche des Wafers ein Film, der im wesentlichen aus Silikaten oder Phosphaten, wie z.B. Natriumsilikat oder Aluminium-Phosphat unter Reinraumbedingungen aufgebracht und insbesondere aufgesponnen wird.

Der Film kann dabei als verdünnte (wässrige) Lösung oder als Film mit einer gewissen, relativ kleinen Restfeuchte eines Lösungsmittels, beispielsweise von Wasser mittels einer sog. Trockenschleuder aufgebracht werden, wie sie in der Halbleiterindustrie zum Aufschleudern von Lackschichten benutzt wird.

Bei dem gezeigten Ausführungsbeispiel besteht der Film aus einer homogenen Natrium-Silikatschicht, die eine Dicke von weniger als 100 nm aufweist. Durch die Homogenität und die geringe Dicke werden die Haftkräfte zwischen den beiden Wafer-Platten erhöht.

Selbstverständlich ist es auch möglich, auf beide Oberflächen jeweils einen Film 3 aufzutragen.

Fig. 3 zeigt, daß die beiden Wafer mit dem dazwischen befindlichen Film bei Raumtemperatur aufeinandergelegt werden. Die starke Adhäsion der beiden hydrophilen Oberflächen sorgt für einen sehr innigen Kontakt der beiden Wafer bzw. Substrate über die gesamte Oberfläche. Bereits die Adhäsionskräfte zwischen den beiden Wafern reichen als Fixierung der beiden Wafer völlig aus und machen ein Verschieben der beiden Oberflächen gegeneinander unmöglich.

Anschließend erfolgt ein Tempervorgang, der bei Temperaturen bis zu 420°C ausgeführt wird. Bevorzugt wird der Tempervorgang jedoch bei Temperaturen ausgeführt, die
- bei Verwendung von Silikatlösungen zwischen 150°C und 300°C und insbesondere 200°C, bzw.
- bei Verwendung von Phosphatlösungen zwischen 300°C und 420°C
liegen.

Die so entstandene Verbindung zeichnet sich sowohl durch eine hohe mechanische Festigkeit, als auch durch eine große mechanische und chemische Beständigkeit aus. Messungen haben ergeben, daß die mechanische Haftkraft im Bereich zwischen (wenigstens) 250 und 300 kg/cm² liegt. Diese sehr hohe Haftkraft ermöglicht eine problemlose Weiterbearbeitung der Wafer-Platten für die Herstellung von z.B. hochkomplexen Mikrostrukturen oder Sensoren oder dgl. mehr. Die weitere Handhabung der beiden miteinander verbundenen Wafer gestaltet sich damit einfach, da die beiden Wafer durch hohe Verbindungskräfte miteinander verbunden sind.

## Patentansprüche

1. Verfahren zur Herstellung einer festen, flächenhaften Verbindung zwischen zwei Wafer-Platten, von denen mindestens eine aus einem halbleitenden Material, besteht,
mit folgenden Schritten:
- auf die gereinigte Oberfläche wenigstens einer Wafer-Platte wird ein Film mit einer Restfeuchte an Lösungsmitteln aufgebracht, der Silikate oder Phosphate enthält,
- die beiden Waferoberflächen, von denen wenigstens auf eine ein Film aufgebracht ist, werden zusammengefügt,
- die beiden Wafer werden im zusammengefügten Zustand bei Temperaturen kleiner als ca 420°C geheizt und dabei getempert.

2. Verfahren nach Anspruch 1,
dadurch **gekennzeichnet**, daß die beiden zusammenzufügenden Waferoberflächen hochpoliert sind.

3. Verfahren nach Anspruch 1 oder 2,
dadurch **gekennzeichnet**, daß das Lösungsmittel Wasser ist.

4. Verfahren nach einem der Ansprüche 1 bis 3,
dadurch **gekennzeichnet**, daß die Schichtdicke des Films maximal 100 nm beträgt.

5. Verfahren nach einem der Ansprüche 1 bis 4,
dadurch **gekennzeichnet**, daß der Tempervorgang bei Temperaturen ausgeführt wird, die
- bei Verwendung von Silikatlösungen zwischen 150°C und 300°C, bzw.
- bei Verwendung von Phosphatlösungen zwischen 300°C und 420°C liegen.

6. Verfahren nach einem der Ansprüche 1 bis 5,
dadurch **gekennzeichnet,** daß die zusammenzufügenden Waferoberflächen vor Aufbringen des Films getrocknet werden.

7. Verfahren nach einem der Ansprüche 1 bis 6,
dadurch **gekennzeichnet**, daß die aufeinandergelegten Wafer-Platten vor dem Tempervorgang ca. 24 Stunden bei Raumtemperatur gelagert werden.

8. Verfahren nach einem der Ansprüche 1 bis 7,
dadurch **gekennzeichnet**, daß die Wafer-Platten metallisierte Bereiche aufweisen.

9. Verfahren nach einem der Ansprüche 1 bis 8,
dadurch **gekennzeichnet**, daß ein Wafer ein Siliziumwafer und das andere Wafer ein Quarzglaswafer ist.

10. Verfahren nach einem der Ansprüche 1 bis 8,
dadurch **gekennzeichnet**, daß ein Wafer ein Siliziumwafer und das andere Wafer ein GaAs-Wafer ist.

11. Verfahren nach einem der Ansprüche 1 bis 8,
dadurch **gekennzeichnet**, daß ein Wafer ein Siliziumwafer und das andere Wafer ein InP-Wafer ist.

12. Verfahren nach einem der Ansprüche 1 bis 8,
dadurch **gekennzeichnet**, daß ein Wafer ein Wafer aus einem halbleitenden Material und das andere Wafer aus optisch aktivem Material, wie z.B. Lithiumniobat, ist.

13. Verfahren nach einem der Ansprüche 1 bis 8,
dadurch **gekennzeichnet**, daß wenigstens ein Wafer auf der zu verbindenden Oberfläche eine Oxidschicht aufweist.

14. Verfahren nach Anspruch 13,
dadurch **gekennzeichnet**, daß die Oxidschicht ein Spin-on-Glas ist.

15. Verfahren nach einem der Ansprüche 1 bis 14,
dadurch **gekennzeichnet**, daß der aufgebrachte Film aus Natriumsilikat besteht.

16. Verfahren nach einem der Ansprüche 1 bis 14,
dadurch **gekennzeichnet**, daß der aufgebrachte Film aus Aluminiumphosphat besteht.

17. Verfahren nach einem der Ansprüche 1 bis 16,
dadurch **gekennzeichnet**, daß die unmittelbar nach dem Zusammenfügen der Wafer-Platten durch den Film verursachten Haftkräfte jegliche Waferverzüge ausgleichen.

18. Verfahren nach einem der Ansprüche 1 bis 17,
dadurch **gekennzeichnet**, daß der Film als Flüssigkeitsfilm aufgebracht wird.

19. Verfahren nach einem der Ansprüche 1 bis 17,
dadurch **gekennzeichnet**, daß das mit einer Restfeuchte behaftete Filmmaterial mit einem Trockenschleuderverfahren aufgebracht wird.

## Claims

1. Method of establishing a stable planar bond between two wafer dices whereof at least one is made of a semiconductor material, comprising the following steps:
- a film having a residual humidity of solvents is applied onto the cleaned surface of at least one wafer dice, which film contains silicates or phosphates,
- the two wafer surfaces, whereof at least one carries a film applied thereon, are bonded to each other,
- the two wafers are heated and thereby annealed in the bonded condition at a temperature below approximately 420 °C.

2. Method according to Claim 1,
**characterized** in that the two wafer surfaces to be bonded are highly polished.

3. Method according to Claim 1 or 2,
**characterized** in that the solvent is water.

4. Method according to any of Claims 1 to 3,
**characterized** in that the thickness of layer of said film amounts to 100 nm at maximum.

5. Method according to any of Claims 1 to 4,
**characterized** in that the annealing operation is performed at a temperature which
- comes under the range between 150 °C and 300 °C, in particular 200 °C, when silicate solutions are employed, or
- under the range from 300 °C to 420 °C when a phosphate solution is used, respectively.

6. Method according to any of Claims 1 to 5,
**characterized** in that the wafer surfaces to be bonded to each other are dried prior to the application of said film.

7. Method according to any of Claims 1 to 6,
**characterized** in that the stacked wafer dices are stored at room temperature for roughly 24 hours prior to the annealing operation.

8. Method according to any of Claims 1 to 7,
**characterized** in that the wafer dices present metallized areas.

9. Method according to any of Claims 1 to 8,
**characterized** in that one wafer is a silicon wafer and the other wafer is a silica glass wafer.

10. Method according to any of Claims 1 to 8,
**characterized** in that one wafer is a silicon wafer and the other wafer is a GaAs wafer.

11. Method according to any of Claims 1 to 8,
**characterized** in that one wafer is a silicon wafer and the other wafer is an lnP wafer.

12. Method according to any of Claims 1 to 8,
**characterized** in that one wafer is a wafer of semiconductor material, and that the other wafer is a wafer made of optically active material such as lithium niobate.

13. Method according to any of Claims 1 to 8,
**characterized** in that at least one wafer presents an oxide layer on the surface to be bonded.

14. Method according to Claim 13,
**characterized** in that the oxide layer is a spin-on glass.

15. Method according to any of Claims 1 to 14,
**characterized** in that the applied film consists of sodium silicate.

16. Method according to any of Claims 1 to 14,
**characterized** in that the applied film consists of aluminium phosphate.

17. Method according to any of Claims 1 to 16,
**characterized** in that the holding forces which are induced by the film immediately after wafer dice bonding compensate any wafer warping.

18. Method according to any of Claims 1 to 17,
**characterized** in that said film is applied in the form of a liquid film.

19. Method according to any of Claims 1 to 17,
**characterized** in that the material of said film, which presents an inherent residual humidity, is applied by a dry centrifuging method.

## Revendications

1. Procédé à établir une liaison ferme superficielle entre deux plaquettes de galette, dont au moins l'une est faite en un matériau semi-conducteur,
comprenant les opérations suivantes:
- on applique un film, à humidité résiduelle de solvants, qui contient des silicates ou phosphates, sur la surface nettoyée d'au moins une plaquette de galette,
- les deux surfaces de galette, dont au moins l'une porte un film y appliquée, sont jointe l'une à l'autre,
- en état lié, les deux galettes sont chauffées, en étant récuites à une température au dessous de 420 °C environ.

2. Procédé selon la revendication 1,
**caractérisé** en ce que les deux surfaces de galette à joindre sont hautement polies.

3. Procédé selon la revendication 1 ou 2,
**caractérisé** en ce que le solvant est de l'eau.

4. Procédé selon une quelconque des revendications 1 à 3,
**caractérisé** en ce que l'épaisseur de couche dudit film est 100 nm au maximum.

5. Procédé selon une quelconque des revendications 1 à 4,
**caractérisé** en ce que l'opération de cuisson se fait à une température qui
- se trouve dans la gamme entre 150 °C et 300 °C, en particulier 200 °C, au cas de l'emploi de solutions de silicate, ou respectivement
- dans la gamme entre 300 °C et 420 °C au cas qu'une solution de phosphate est utilisée.

6. Procédé selon une quelconque des revendications 1 à 5,
**caractérisé** en ce que les surfaces de galette à joindre l'une à l'autre sont séchées avant le dépôt dudit film.

7. Procédé selon une quelconque des revendications 1 à 6,
**caractérisé** en ce que les plaquettes de galette posées l'une sur l'autre sont stockées à température ambiante pour 24 heures environ, avant l'opération de cuisson.

8. Procédé selon une quelconque des revendications 1 à 7,
**caractérisé** en ce que les plaquettes de galette présentent des aires métallisées.

9. Procédé selon une quelconque des revendications 1 à 8,
**caractérisé** en ce qu'une galette est une galette en silicium, et que l'autre galette est une galette de verre quartzeux.

10. Procédé selon une quelconque des revendications 1 à 8,
**caractérisé** en ce qu'une galette est une galette en silicium, et que l'autre galette est une galette en GaAs.

11. Procédé selon une quelconque des revendications 1 à 8,
**caractérisé** en ce qu'une galette est une galette en silicium, et que l'autre galette est une galette en lnP.

12. Procédé selon une quelconque des revendications 1 à 8,
**caractérisé** en ce qu'une galette est une galette en un matériau semi-conducteur, et que l'autre galette est une galette en un matériau à action optique, comme le niobate de lithium.

13. Procédé selon une quelconque des revendications 1 à 8,
**caractérisé** en ce qu'au moins une galette présente une couche d'oxyde sur la surface à joindre.

14. Procédé selon la revendication 13,
**caractérisé** en ce que la couche d'oxyde est un verre filable, du type dit "spin- on"

15. Procédé selon une quelconque des revendications 1 à 14,
**caractérisé** en ce que le film appliqué est formé par silicate de sodium.

16. Procédé selon une quelconque des revendications 1 à 14,
**caractérisé** en ce que le film appliqué est formé par phosphate d'aluminium.

17. Procédé selon une quelconque des revendications 1 à 16,
**caractérisé** en ce que les forces de retenue, qui sont provoquée directement après la jonction desdites plaquettes de galette par le film, compensent toute déformation desdites galettes.

18. Procédé selon une quelconque des revendications 1 à 17,
**caractérisé** en ce que ledit film est déposé sous forme d'une pellicule de liquide.

19. Procédé selon une quelconque des revendications 1 à 17,
**caractérisé** en ce que le matériau dudit film, qui présente une humidité résiduelle, est déposé par une opération de centrifugation à sec.
